# EUROPEAN PATENT SPECIFICATION

(11) **EP 1 173 051 B1**
(45) Date of publication and mention of the grant of the patent: **23.05.2007**
(21) Application number: 00900913.5
(22) Date of filing: 25.01.2000
(51) Int. Cl.: H05K 1/14, H05K 3/36, H05K 3/00, H05K 3/40

(54) **FLEXIBLE PRINTED WIRING BOARD AND ITS PRODUCTION METHOD**
FLEXIBLE GEDRUCKTE LEITERPLATTE UND IHRE HERSTELLUNGSMETHODE
CARTE DE CIRCUITS IMPRIMES FLEXIBLE ET SON PROCEDE DE PRODUCTION

(43) Date of publication of application: 16.01.2002
(73) Proprietor: Sony Chemical & Information Device Corporation, Tokyo 141-0032 (JP)
(72) Inventor: Kurita, Hideyuki, Kanuma-shi Tochigi 322-8502 (JP); Taniguchi, Masato, Kanuma-shi Tochigi 322-8502 (JP)
(74) Representative: TBK-Patent
(86) International application number: PCT/JP2000/000344
(87) International publication number: WO 2001/056339

(56) References cited:
- JP-A- 6 112 620
- JP-A- 6 132 618
- JP-A- 6 287 326
- JP-A- 7 090 243
- JP-A- 7 202 373
- JP-A- 7 297 541
- JP-A- 10 189 088
- US-A- 4 626 961
- US-A- 5 118 386
- US-A- 5 317 438
- US-A- 5 873 161
- PATENT ABSTRACTS OF JAPAN vol. 1996, no. 03, 29 March 1996 (1996-03-29) & JP 7 297541 A (MICRO GIJUTSU KENKYUSHO:KK), 10 November 1995 (1995-11-10)
- PATENT ABSTRACTS OF JAPAN vol. 0183, no. 88 (E-1581), 20 July 1994 (1994-07-20) & JP 6 112620 A (MINOLTA CAMERA CO LTD), 22 April 1994 (1994-04-22)
- PATENT ABSTRACTS OF JAPAN vol. 1995, no. 11, 26 December 1995 (1995-12-26) & JP 7 202373 A (KEL CORP), 4 August 1995 (1995-08-04)
- PATENT ABSTRACTS OF JAPAN vol. 1995, no. 01, 28 February 1995 (1995-02-28) & JP 6 287326 A (SUMITOMO BAKELITE CO LTD), 11 October 1994 (1994-10-11)
- PATENT ABSTRACTS OF JAPAN vol. 1998, no. 12, 31 October 1998 (1998-10-31) & JP 10 189088 A (JSR CORP), 21 July 1998 (1998-07-21)

## Description

### TECHNICAL FIELD

The present invention relates to a flexible printed wiring board and a method of manufacturing it.

### BACKGROUND ART

Conventionally, flexible printed wiring boards are employed in various different fields, and their shapes are various.

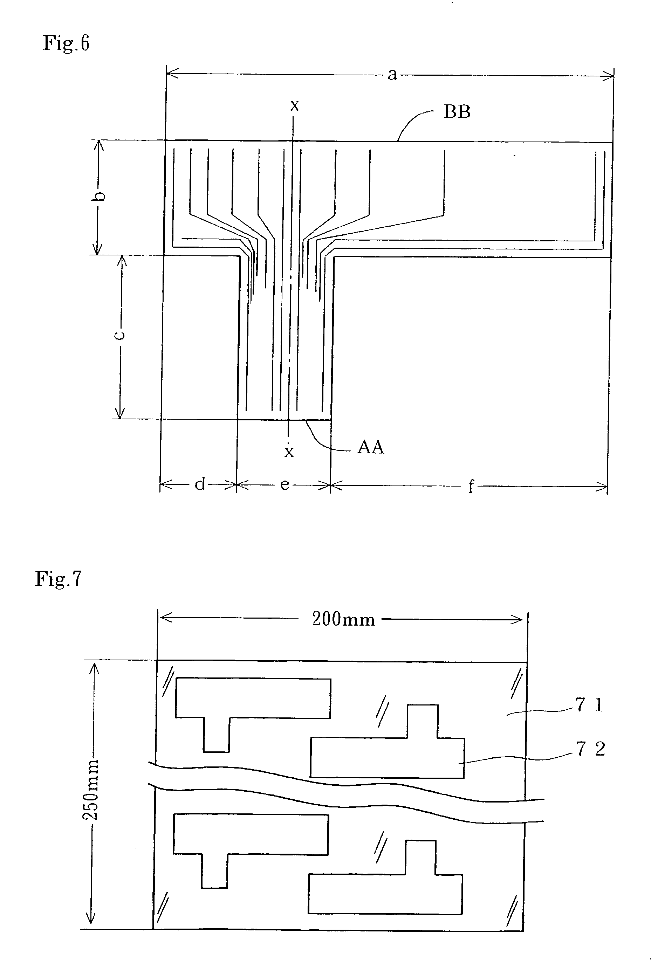

For example, a typical flexible printed wiring board for use in driving a liquid crystal panel may be of the T-shaped type as shown in Fig. 6. The terminals on the BB side are formed with relatively wide wiring pitch so that they can pass signals to the IC in a bundled fashion; on the other hand, the terminals on the AA side are formed with comparatively narrow wiring pitch so that they can be connected to a miniature semiconductor module for drive purposes.

When manufacturing flexible printed wiring boards of T-shape as in Fig. 6, a plurality of T-shaped flexible printed wiring boards per unit area of a laminated sheet for flexible printed wiring purposes obtained by forming insulating layers on conductive layers are created, and this sheet is cut to produce the individual wiring boards. Specifically, as shown in Fig. 7, T-shaped flexible printed wiring boards as shown in Fig. 6 (size: a=160 mm/b=17 mm/c=30 mm/d=20 mm/e=25 mm/f=115 mm) are created by the additive or subtractive method, utilizing a photolithographic technique or the like in a flexible printed wiring laminated sheet 71 of size: length 250 mm, width 200 mm.

However, when T-shaped flexible printed wiring boards 72 were created in a laminated sheet 71 for flexible printed wiring as shown in Fig. 7, about 58% of the laminated sheet 71 for flexible printed wiring was discarded, presenting an obstacle to a reduction in manufacturing costs. This problem becomes more severe as the height (depth) of irregularities of the external shape of the flexible printed wiring board and or its complexity increase.

In view of the above problems of the prior art, an object of the present invention is to confer on a flexible printed wiring board a structure such that as many as possible flexible printed wiring boards can be obtained from a laminated sheet for flexible printed wiring of a prescribed size.

US-A-5 873 161 discloses methods for making Z-axis electrical connections in multi-layered circuits, and multi-layered circuits made by these methods. Specifically, the circuit layer interconnections are made with deformable electrically conducting materials, in the form of bumps, that create electrical connections between adjacent circuit layers, thus providing electrical conduction along the Z-axis. The deformability of the bumps also allows for bump height non-uniformity in creating reliable electrical connections.

### DISCLOSURE OF THE INVENTION

The present inventors perfected the present invention by discovering that: (1) when creating flexible printed wiring boards in a laminated sheet for flexible printed wiring, the amount of laminated sheet discarded could be reduced by creating the flexible printed wiring boards divided into at least two parts; (2) when producing a single flexible printed wiring board by joining at the two parts, it is preferable for connection reliability that bump connection is achieved when the front face side of one part is connected with the back face side of the other part; (3) if bumps are employed that are obtained by forming holes by chemical etching utilizing a photolithographic method in the insulating layer of the laminated sheet for flexible printed wiring, then filling these holes with metal plugs by an electrolytic plating method and further growing these to metal bumps, it is not necessary to make the positional alignment accuracy excessively high when forming the holes, thereby making it possible to introduce the metal bumps with low cost.

Specifically, the present invention provides a flexible printed wiring board as defined in claim 1.

Also, the present invention provides a method of manufacturing such a flexible printed wiring board as defined in claim 5.

### BRIEF DESCRIPTION OF THE DRAWINGS

Fig. 1A is a plane view of one example of a flexible printed wiring board according to the present invention and Fig. 1B is a cross sectional view along x-x thereof;
Fig. 2 is a plane view of a laminated sheet for flexible printed wiring in which first and second flexible printed wiring parts employed in the present invention are created;
Fig. 3 is a surface view on the side of the metal bump face of a first flexible printed wiring part employed in the present invention;
Figs.4A to 4D are diagrams of the steps of manufacturing a flexible printed wiring board according to the present invention;
Figs. 5E to 5I are diagrams of the steps of manufacturing a flexible printed wiring board according to the present invention;
Fig. 6 is a plane view of a prior art flexible printed wiring board; and
Fig. 7 is a plane view of a laminated sheet for flexible printed wiring in which conventional flexible printed wiring boards have been created.

### BEST MODE FOR CARRYING OUT THE INVENTION

Hereinbelow, an example of a flexible printed wiring board according to the present invention is described in detail with reference to the drawings.

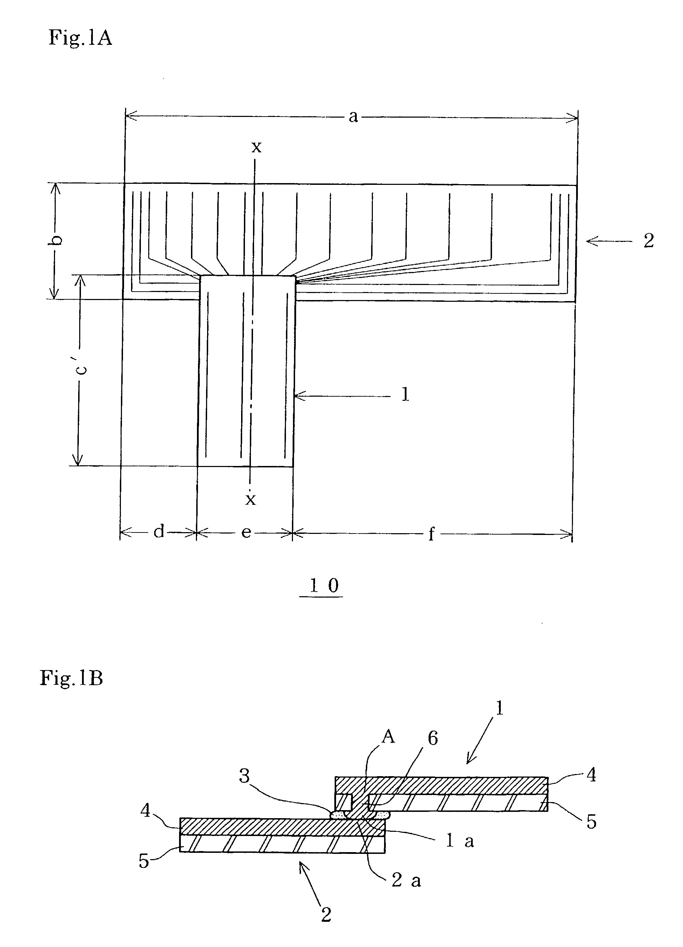

Flexible printed wiring board 10 of Figs. 1A and 1B, the former being a plane view thereof and the latter being a cross section along x-x thereof, has a construction wherein first flexible printed wiring part 1 and second flexible printed wiring part 2 are stuck together by an adhesive layer 3 such that metal bump 1a of first flexible printed wiring part 1 and connection pad 2a of second flexible printed wiring part 2 are electrically connected. A reduction in the amount of laminated sheet discarded when the flexible printed wiring boards are created in the laminated sheet for flexible printed wiring can thus be achieved by adopting a construction wherein a flexible printed wiring board 10 is obtained by joining at least two parts (1, 2).

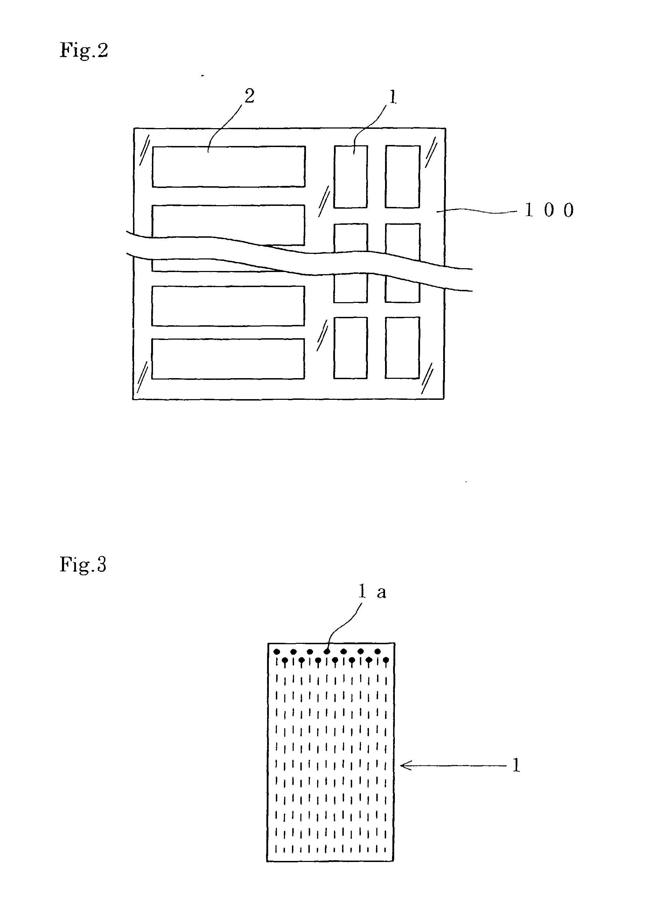

For example, when the T-shaped flexible printed wiring board of Fig. 6 (size: a=160 mm/b=17 mm/c=30 mm/d=20 mm/e=25 mm/f=115 mm) is divided into a first flexible printed wiring part 1 (size: c'=35 mm/e=25 mm) and a second flexible printed wiring part 2 (size: a=160 mm/b=17 mm), these being created in a laminated sheet 100 for flexible printed wiring of size length 200 mm and width 250 mm as shown in Fig. 2, 10 sheets in each case can be respectively created; thus, compared with the case of Fig. 7 (58.4%), the discard ratio can be very considerably lowered, to 28.1%.

Also, metal bump 1a of the first flexible printed wiring part 1 in the present invention, as shown in Fig. 1B, is a portion where the tip of a metal plug 6 formed by an electrolytic plating method projects from insulating layer 5 into the interior of hole A formed by chemical etching using a photolithographic method, in the insulating layer 5 adjacent to conductive layer 4 of first flexible printed wiring part 1. In this way, metal bump 1a is capable of being formed conveniently and with low cost on the surface of first flexible printed wiring part 1.

The second flexible printed wiring part 2 is provided with an ordinary connection pad 2a in the portion adjacent to metal bump 1a of the first flexible printed wiring part 1, but otherwise comprises the same layer structure as a known flexible printed wiring board, such as for example conductive layer 4 and insulating layer 5 adjacent thereto.

Typically conductive layer 4 is made of copper foil, but it could be formed of another metal, gold, silver, aluminum, solder, nickel or the like or alloys of these.

The thickness of conductive layer 4 may be suitably determined in accordance with the object of use of the wiring board. Also, conductive layer 4 may be patterned in accordance with requirements.

According to the present invention, for insulating layer 5, the same construction may be adopted as for the insulating layer of a typical flexible printed wiring board; preferably, a polyimide layer, which is of excellent insulating properties, heat resistance, humidity resistance and voltage withstanding properties may desirably be employed. Use of a polyimide layer obtained by imidizing a polyamic acid is particularly preferable. This is because the holes can be precisely and conveniently formed prior to the imidizing step by chemical etching.

Also, the thickness of insulating layer 5 can be suitably determined in accordance with the object of use of the flexible printed wiring board.

As adhesive layer 3, an adhesive layer may be employed comprising adhesive used in manufacturing ordinary flexible printed wiring boards. For example, the generally known anisotropic conductive films, thermoplastic polyimides, epoxy resins or the like may be mentioned by way of example. Of these, an insulating thermoplastic polyimide layer, which has excellent affinity with insulating layer 5, insulating properties, heat resistance, resistance to humidity and voltage withstanding properties is preferably employed.

As metal plug 6 with which hole A is filled and as the metal bump 1a at the tip thereof projecting from insulating layer 5, as described above, a metallic substance formed by an electrolytic plating method, preferably an electrolytic copper plating plug (electrolytic copper plating bump) may be employed.

The diameter and height of metal plug 6 and the diameter and height of metal bump 1a can be suitably determined in accordance with the object of use of the flexible printed wiring board.

The surface of metal bump 1a of first flexible printed wiring part 1 may be suitably formed with a plated layer of noble metal such as gold in accordance with requirements in order to improve reliability of conduction.

The metal bumps 1a are arranged in a zigzag fashion as shown in Fig. 3. In this way, the wiring pitch can be reduced, and the flexible printed wiring board and the electronic equipment that employs this can be reduced in size and weight. In this case, the connection pads of the second flexible printed wiring part are correspondingly arranged in zigzag fashion.

Next, each of the steps of a method of manufacturing a flexible printed wiring board according to the present invention will be described with reference to the drawings, taking as an example a case in which thermoplastic polyimide film is employed as adhesive layer 3.

### Step (a)

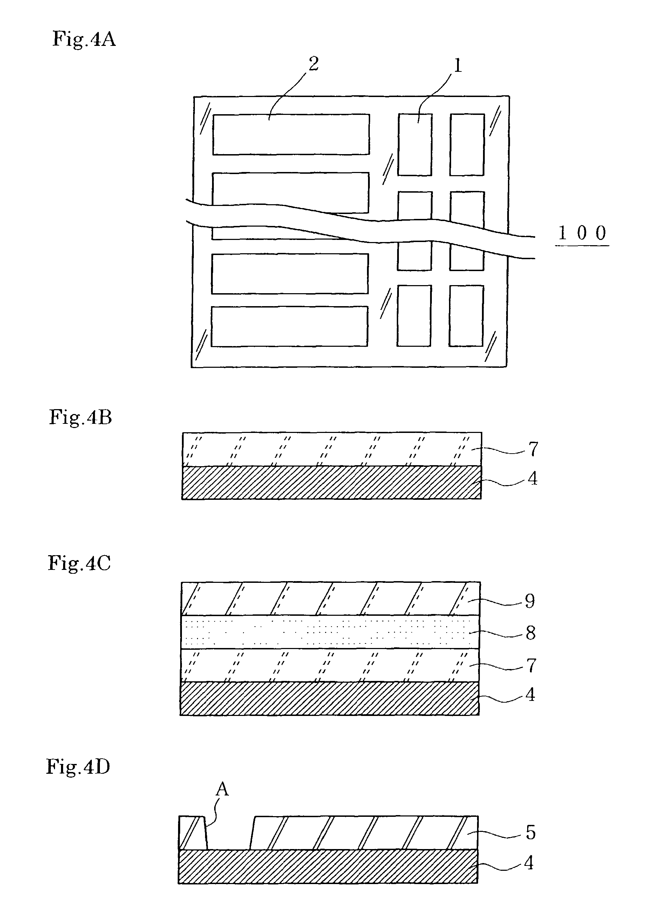

First of all, first flexible printed wiring parts 1 and second flexible printed wiring parts 2 are created (Fig. 4A) in a laminated sheet 100 for flexible printed wiring formed of a conducting layer and an insulating layer adjacent thereto, in such a way that as many as possible of first flexible printed wiring parts 1 and second flexible printed wiring parts 2 can be obtained per unit area. First flexible printed wiring parts 1 and second flexible printed wiring parts 2 may be created in separate laminated sheets 100 for flexible printed wiring or both may be created in a single laminated sheet 100 for flexible printed wiring.

First flexible printed wiring parts 1 are manufactured as follows.

The second flexible printed wiring parts 2 may be created using known techniques.

### Step (aa)

Holes A reaching conductive layer 4 are formed by chemical etching utilizing a photolithographic method in insulating layer 5 adjacent to conductive layer 4. More specifically, an insulating layer precursor layer 7 is formed by applying polyamic acid on to conductive layer 4 and drying (Fig. 4B). A photosensitive resist layer 8 is then formed by applying photosensitive resist thereon and drying and, in addition, a protective film 9 is laminated thereon (Fig. 4C). Patterning of photosensitive resist layer 8 is then performed by exposure through a photomask corresponding to the holes that are to be formed, and developing, and chemical etching is then carried out of the insulating layer precursor layer 7, using the patterned photosensitive resist layer 8 as an etching mask. After completion of etching, imidization is performed by the ordinary method, and an insulating layer 5 is formed (Fig. 4D) having holes A by removal of the photosensitive resist layer 8 and protective film 9.

The chemical etching conditions may be suitably determined in accordance with the material of the insulating layer precursor layer 7 and the size etc of holes A that are to be formed.

### Step (ab)

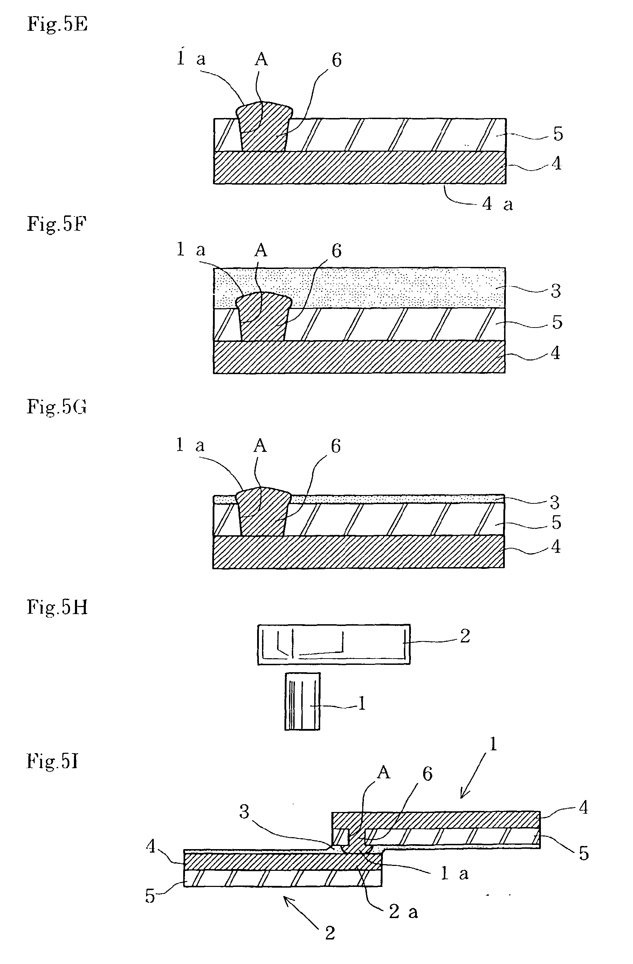

Next, the metal plugs 6 are formed within holes A of insulating layer 5 by an electrolytic plating method of conductive layer 4 that are to constitute cathodes and these metal plugs 6 are continuously grown by further an electrolytic plating method, so that the tips thereof constitute metal bumps 1a (Fig. 5E) projecting from the surface of insulating layer 5. When this is done, preferably the outside surface 4a of conductive layer 4 is covered with masking tape (not shown).

The electrolytic plating conditions may be suitably determined in accordance with the type of plating metal and hole diameter, the plug size and the like that is to be formed.

Also, this masking tape may be removed prior to the subsequent plating step (ac) when forming adhesive layer 3, or, although not shown, may be maintained in this condition up to the final step.

### Step (ac)

Next, adhesive layer 3 is formed (Fig. 5F) on the surface of insulating layer 5 formed with metal bumps 1a, so as to submerge metal bumps 1a if required.

Formation of adhesive layer 3 may be achieved for example by applying a thermoplastic polyimide solution using a knife coater, then drying.

### Step (ad)

Next, chemical etching-back of the surface of adhesive layer 3 is performed so that metal bumps 1a have a prescribed height. In this way, the first flexible printed wiring parts provided with adhesive layer 3 on their surface are obtained (Fig. 5G).

The conditions of chemical etching back of adhesive layer 3 may be suitably determined in accordance with the material of adhesive layer 3, the material of metal bumps 1a, and the required amount of etch-back etc. For example, if adhesive layer 3 is a thermoplastic polyimide layer, an aqueous solution of alkali can be employed as etchant.

### Step (b)

Next, the individual parts are divided out (Fig. 5H) from the laminated sheet for flexible printed wiring by cutting out first flexible printed wiring parts 1 and second flexible printed wiring parts 2.

### Step (c)

The first flexible printed wiring part 1 and second flexible printed wiring part 2 thus obtained are stuck together by adhesive layer 3 while establishing connection of metal bumps 1a and connection pads 2a. In this way, the flexible printed wiring board of Fig. 5I is obtained without using anisotropic conductive adhesive film or conductive paste.

A flexible printed wiring board in accordance with Figs. 1A and 1B is obtained by sticking together first flexible printed wiring part 1 and second flexible printed wiring part 2 in the condition of Fig. 5E using separately provided anisotropic conductive adhesive film or conductive paste.

The flexible printed wiring board which is thus obtained may be advantageously applied to various types of electronic equipment.

### EXAMPLES

The present invention is described in detail below with reference to Practical Examples.

### Example 1

A solution of polyamic acid obtained by dissolving 1.01 mol of pyromellitic acid dianhydride and 1.0 mol of 4, 4'-diaminodiphenyl ether in N-methyl-2-pyrrolidone as solvent was applied to one face of copper foil of thickness 18 µm to give a dry thickness of 10 µm, then dried.

A photosensitive resist (NR-41 (nylon-oligoester based resist), manufactured by Sony Chemical Corporation) was applied on to this polyamic acid layer so as to provide a dry thickness of 8 µm, then dried, and, in addition, a further protective film of thickness of 12 µm (polyester film, manufactured by Toray Corporation) was laminated thereon.

The photosensitive resist was patterned into first flexible printed wiring parts and second flexible printed wiring parts, ten in each case, per unit area (200 X 250 mm), by exposing the photosensitive resist by illuminating with light of wavelength 365 nm from the side of the protective film, using a negative film as photomask, and developing.

Using the patterned photosensitive resist as etching mask, holes were formed in the polyamic acid layer constituting the first flexible printed wiring part by chemical etching of the polyamic acid layer (etching temperature 25°C, etching time 15 seconds) with an alkaline solution. The copper foil was exposed at the bottom of the holes, the diameter of the bottom being 50 µm, and the diameter of the holes at the surface of the polyamic acid layer being 80 µm.

Next, an insulating layer was produced by imidizing the polyamic acid layer in which the holes were formed (imidization heating temperature 350°C, imidization heating time 10 minutes).

Next, after covering the outer surface of the copper foil with masking tape, electrolytic copper plating was performed using the copper foil as cathode (copper sulfate plating bath, plating bath temperature 30°C, plating current density 15 A/dm², plating time 30 minutes). As a result, copper bumps were formed projecting to a height of 20 µm from the surface of the insulating layer of the first flexible printed wiring parts.

Next, a polyamic acid solution obtained by dissolving 1.01 mol of 3, 4, 3', 4'-biphenyl-tetracarboxylic acid dianhydride and 1.0 mol of 1, 3-bis(3-aminophenoxy)benzene in N-methyl-2-pyrrolidone solvent was applied using a knife coater so as to form a thermoplastic polyimide layer (adhesive layer) of dry thickness 20 µm over the entire surface of the insulating layer on the copper bump side; drying was then performed.

Next, chemical etch back (etch back temperature 25°C, etch-back time 15 seconds) was performed using an aqueous solution of alkali on the surface of the adhesive layer such that the exposed heights of the copper bumps became 10 µm; a thermoplastic polyimide layer was then completed by imidizing the polyamic acid; first flexible printed wiring parts and second flexible printed wiring parts as shown in Fig. 2, were thereby manufactured.

The first flexible printed wiring parts and second flexible printed wiring parts which were thus obtained were respectively released. When the metal bumps of the first flexible printed wiring parts were superimposed on the connection pads of the second flexible printed wiring parts and joined by hot pressure fixing (joining temperature 260°C, joining time 10 seconds), it was found possible to achieve joints of high adhesive strength and reliable conduction.

### INDUSTRIAL APPLICABILITY

A flexible printed wiring board according to the present invention can be manufactured by utilizing a laminated sheet for flexible printed wiring of a prescribed size without waste, so it can be manufactured with low cost and furthermore has excellent conduction reliability.

## Claims

1. A flexible printed wiring board (10) comprising
a first flexible printed wiring part (1) having metal bumps (1a) and
a second flexible printed wiring part (2) having connection pads (2a), wherein
the first flexible printed wiring part (1) comprises a conductive layer (4) and an insulating layer (5) adjacent thereto; holes are provided in the insulating layer (5) so as to reach the conductive layer (4); metal plugs (6) are formed in said holes by an electrolytic plating method; and the tips of said metal plugs (6) constitute the metal bumps (1a) that project from the insulating layer (5),
**characterized in that**
the metal bumps (1a) and the connection pads (2a) are connected to each other and,
the metal bumps (1a) of the first flexible printed wiring part (1) and the connection pads (2a) of the second flexible printed wiring part (2) are arranged in a zigzag fashion.

2. The flexible printed wiring board according to claim 1, wherein the insulating layer is a polyimide layer and the metal plugs are electrolytic copper plating plugs.

3. The flexible printed wiring board according to claim 2, wherein the insulating layer is obtained by imidizing polyamic acid.

4. The flexible printed wiring board according to any of claims 1 to 3, wherein the first flexible printed wiring part and the second flexible printed wiring part are stuck together by an anisotropic conductive film, thermoplastic polyimide, or epoxy resin.

5. A method of manufacturing a flexible printed wiring board according to claim 1, comprising:
(a) a step of creating first flexible printed wiring parts (1) and second flexible printed wiring parts (2) in a laminated sheet (100) for flexible printed wiring composed of a conductive layer (4) and an insulating layer (5) formed adjacent thereto, such that as many as possible first flexible printed wiring parts and/or second flexible printed wiring parts can be obtained per unit area of the laminated sheet;
in which metal bumps (1a) of the first flexible printed wiring parts (1) are created in a zigzag fashion by forming holes in the insulating layer (5) adjacent to the conductive layer (4), so as to reach the conductive layer (4), by chemical etching using a photolithographic method, then, while forming metal plugs (6) in the holes of the insulating layer (5) by an electrolytic plating method in which the conductive layer (4) is used as the cathode, further continuously growing these metal plugs (6) by an electrolytic plating method so that the tips thereof project from the surface of the insulating layer;
(b) a step of obtaining the first flexible printed wiring parts (1) and the second flexible printed wiring parts (2) from the laminated sheet for flexible printed wiring by cutting the same;
**characterized in that,**
the metal bumps (1a) of the first flexible printed wiring part (1) and connection pads (2a) of the second flexible printed wiring part (2) are arranged in a zigzag fashion, and the method further comprises
(c) a step of sticking together the first flexible printed wiring parts (1) and the second flexible printed wiring parts (2) that have thus been obtained while ensuring conduction between the metal bumps (1a) of the first flexible printed wiring parts (1) and the connection pads (2a) of the second flexible printed wiring parts (2).

## Patentansprüche

1. Flexible gedruckte Leiterplatte (10) enthaltend ein erstes flexibles gedrucktes Leiterteil (1) mit Metallerhebungen (1a) und
ein zweites flexibles gedrucktes Leiterteil (2) mit Kontaktflächen (2a), wobei
das erste flexible gedruckte Leiterteil (1) eine leitende Schicht (4) und eine daran angrenzende isolierende Schicht (5) enthält; Löcher sind in der isolierenden Schicht (5) vorgesehen, um die leitende Schicht (4) zu erreichen; in den Löchern sind Metallstecker (6) durch ein elektrolytisches Plattierungsverfahren gebildet; und die Spitzen der Metallstecker (6) bilden die aus der isolierenden Schicht (5) herausragenden Metallerhebungen (1a), **gekennzeichnet dadurch, dass** die Metallerhebungen (1a) und die Kontaktflächen (2a) miteinander verbunden sind, und
die Metallerhebungen (1a) des ersten flexiblen gedruckten Leiterteils (1) und die Kontaktflächen (2a) des zweiten flexiblen gedruckten Leiterteils (2) in einer Zickzack-Anordnung angeordnet sind.

2. Flexible gedruckte Leiterplatte nach Anspruch 1, wobei die isolierende Schicht eine Polyimidschicht ist und die Metallstecker
Elektrolytkupferplattierstecker sind.

3. Flexible gedruckte Leiterplatte nach Anspruch 2, wobei die isolierende Schicht durch Imidierung einer Polyamidsäure (polyamic acid) erhalten ist.

4. Flexible gedruckte Leiterplatte nach einem der Ansprüche 1 bis 3, wobei das erste flexible gedruckte Leiterteil und das zweite flexible gedruckte Leiterteil durch einen anisotrop leitenden Film, ein thermoplastisches Polyimid oder ein Epoxidharz zusammengeklebt sind.

5. Verfahren zur Herstellung einer flexiblen gedruckten Leiterplatte nach Anspruch 1, enthaltend:
(a) einen Schritt der Erstellung von ersten flexiblen gedruckten Leiterteilen (1) und zweiten flexiblen gedruckten Leiterteilen (2) in einem laminierten Sheet (100) für flexible gedruckte Leiter, zusammengesetzt aus einer leitenden Schicht (4) und einer daran angrenzenden isolierenden Schicht (5), so dass so viele erste flexible gedruckte Leiterteile (1) und/oder zweite flexible gedruckte Leiterteile (2) wie möglich pro Flächeneinheit des laminierten Sheets erhalten werden können;
in welchem Metallerhebungen (1a) der ersten flexiblen gedruckten Leiterteile (1) in einer Zickzack-Anordnung erstellt werden, indem durch chemisches Ätzen unter Verwendung eines photolithographischen Verfahrens, Löcher in der an die leitende Schicht (4) angrenzenden isolierenden Schicht (5) gebildet werden, um die leitende Schicht (4) zu erreichen, dann, indem durch ein elektrolytisches Plattierungsverfahren, in dem die leitende Schicht (4) als die Kathode verwendet wird, in den Löchern der isolierenden Schicht (5) Metallstecker (6) gebildet werden, diese Metallstecker (6) mittels eines elektrolytischen Plattierungsverfahrens weiter kontinuierlich anwachsen, so dass die Spitzen davon von der Oberfläche der isolierenden Schicht herausragen;
(b) einen Schritt des Erhaltens der ersten flexiblen gedruckten Leiterteile (1) und der zweiten flexiblen gedruckten Leiterteile (2) aus dem laminierten Sheet durch Schneiden des selbigen; und **dadurch gekennzeichnet, dass**
die Metallerhebungen (1a) des ersten flexiblen gedruckten Leiterteils (1) und Kontaktflächen (2a) des zweiten flexiblen gedruckten Leiterteils (2) in einer Zickzack-Anordnung angeordnet sind, und das Verfahren des Weiteren enthält
(c) einen Schritt des Zusammenhaltens der so erhaltenen ersten flexiblen gedruckten Leiterteile (1) und der zweiten flexiblen gedruckten Leiterteile (2), während eine Leitung zwischen den Metallerhebungen (1a) der ersten flexiblen gedruckten Leiterteile (1) und den Kontaktflächen (2a) der zweiten flexiblen gedruckten Leiterteile (2) sichergestellt ist.

## Revendications

1. Carte à câblage imprimé souple (10) comprenant
une première partie de câblage imprimé souple (1) comportant des bosses métalliques (1a) et
une seconde partie de câblage imprimé souple (2) comportant des plages de connexion (2a), dans laquelle
la première partie de câblage imprimé souple (1) comprend une couche conductrice (4) et une couche isolante (5) adjacente à celle-ci, des trous sont prévus dans la couche isolante (5) de manière à atteindre la couche conductrice (4), des fiches métalliques (6) sont formées dans lesdits trous par un procédé de plaquage électrolytique et les bouts desdites fiches métalliques (6) constituent les bosses métalliques (1a) qui dépassent de la couche isolante (5),
**caractérisé en ce que**
les bosses métalliques (1a) et les plages de connexion (2a) sont connectées les unes aux autres, et
les bosses métalliques (1a) de la première partie de câblage imprimé souple (1) et les plages de connexion (2a) de la seconde partie de câblage imprimé souple (2) sont agencées selon une manière en zigzag.

2. Carte à câblage imprimé souple selon la revendication 1, dans lequel la couche isolante est une couche de polyimide et les fiches métalliques sont des fiches à placage de cuivre électrolytique.

3. Carte à câblage imprimé souple selon la revendication 2, dans laquelle la couche isolante est obtenue en ajoutant un groupement polyimide à l'acide polyamide.

4. Carte à câblage imprimé souple selon l'une quelconque des revendications 1 à 3, dans laquelle la première partie de câblage imprimé souple et la seconde partie de câblage imprimé souple sont collées ensemble par un film conducteur anisotrope, un polyimide thermoplastique ou une résine époxy.

5. Procédé de fabrication d'une carte à câblage imprimé souple selon la revendication 1, comprenant :
(a) une étape de création des premières parties de câblage imprimé souple (1) et des secondes parties de câblage imprimé souple (2) dans une feuille stratifiée (100) pour un câblage imprimé souple composé d'une couche conductrice (4) et d'une couche isolante (5) formée de manière adjacente à celle-ci, de sorte qu'autant que possible des premières parties de câblage imprimé souple et/ou des secondes parties de câblage imprimé souple peuvent être obtenues par surface élémentaire de la feuille stratifiée,
dans lequel les bosses métalliques (1a) des premières parties de câblage imprimé souple (1) sont créées selon une manière en zigzag en formant des trous dans la couche isolante (5) adjacente à la couche conductrice (4) de manière à atteindre la couche conductrice (4) par gravure chimique en utilisant un procédé photolithographique puis, tout en formant des fiches métalliques (6) dans les trous de la couche isolante (5) par le biais d'un procédé de plaquage électrolytique dans lequel la couche conductrice (4) est utilisée en tant que cathode, en faisant en outre croître de manière continue ces fiches métalliques (6) par le biais d'un procédé de plaquage électrolytique de sorte que leurs bouts dépassent de la surface de la couche isolante,
(b) une étape consistant à obtenir les premières parties de câblage imprimé souple (1) et les secondes parties de câblage imprimé souple (2) à partir de la feuille stratifiée en vue d'un câblage imprimé souple en découpant celle-ci,
et **caractérisé en ce que**,
les bosses métalliques (1a) de la première partie de câblage imprimé souple (1) et les plages de connexion (2a) de la seconde partie de câblage imprimé souple (2) sont agencées selon une manière en zigzag, et
le procédé comprend en outre
(c) une étape consistant à coller ensemble les premières parties de câblage imprimé souple (1) et les secondes parties de câblage imprimé souple (2) qui ont été ainsi obtenues tout en assurant une conduction entre les bosses métalliques (1a) des premières parties de câblage imprimé souple (1) et les plages de connexion (2a) des secondes parties de câblage imprimé souple (2).
